# EUROPEAN PATENT APPLICATION

(11) **EP 4 645 688 A1**
(43) Date of publication of application: **05.11.2025**
(21) Application number: 24173153.8
(22) Date of filing: 29.04.2024
(51) Int. Cl.: H03F 1/02, H03F 3/187, H03G 3/00

(54) **APPARATUS AND METHOD FOR ADAPTIVE BOOST VOLTAGE ADJUSTMENT IN DC-DC BOOST CONVERTER**

(71) Applicant: Goodix Technology (HK) Company Limited, Sheung Shui (HK)
(72) Inventor: ABBASI ALAEI, Masoud, 6537 TL Nijmegen (NL); VAN DOMMELEN, Maarten Wilhelmus Henricus Marie, 6537 TL Nijmegen (NL)
(74) Representative: Lippert Stachow Patentanwälte Rechtsanwälte Partnerschaft mbB

(57) **Abstract**

1. The invention relates to an apparatus for adaptive boost voltage adjustment comprising a DC-DC control unit for controlling and adjusting an input voltage of a DC-DC boost converter connected to the DC-DC control unit, an amplifier for amplifying an audio input signal coupled to the amplifier and outputting an output signal coupled to a load, whereas the amplifier is powered by an adaptive DC-DC boost converter, and the adaptive DC-DC boost converter is powered by a battery, whereas the apparatus further comprises a battery monitoring circuitry which is configured to monitor an output voltage of the battery and to regulate an amplitude of the amplifier's output signal accordingly. The objective of the present invention to provide a cost-efficient and effective apparatus and a method that achieves an optimal power management between a battery monitoring circuitry and an adaptive DC-DC boost converter, thereby minimizing battery power consumption and enhancing overall battery life, is solved therein that the DC-DC control unit comprises an amplifier gain adjustment input for adjusting a boost voltage of the adaptive DC-DC boost converter based on the output of the battery monitoring circuitry (17).

## Description

### Technical Field

The invention discloses an apparatus for adaptive boost voltage adjustment comprising a DC-DC control unit for controlling and adjusting an input voltage of a DC-DC boost converter connected to the DC-DC control unit, an amplifier for amplifying an audio input signal coupled to the amplifier and outputting an output signal coupled to a load, whereas the amplifier is powered by the DC-DC boost converter, and the DC-DC boost converter is powered by a battery, whereas the apparatus further comprises a battery monitoring circuitry which is configured to monitor an output voltage of the battery and to regulate the amplifier's output signal accordingly.

### Background Art

Portable audio devices, like mobile phones, cordless phones, mp3 players, and other consumer audio gadgets, are widely being used. These devices typically include a power amplifier to drive the output audio signal to a load, such as a speaker. In simple terms, a power amplifier enhances an audio signal by drawing energy from a power supply and adjusting the output signal to match the input signal shape but with a higher amplitude.

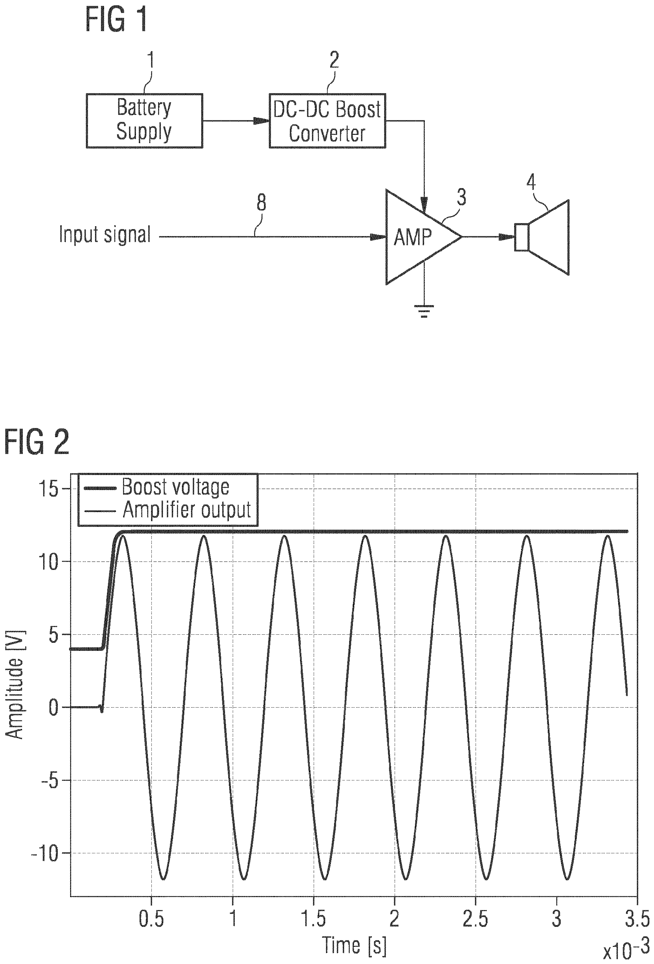

In many devices, a boost converter acts as the power supply, providing the necessary electrical energy for the power amplifier's output. Fig. 1 shows a block diagram of an electronic circuit using a DC-DC boost converter. A DC-DC boost converter (2) is a component that increases a direct current (DC) voltage, usually from a battery (1) to a higher level. Importantly, most of the current that the power amplifier (3) sends to the load (4) comes from this DC-DC boost converter (2). An audio input signal (8) is inputted to the amplifier (3), and the audio input signal (8) is amplified by the amplifier (3), whereas the DC-DC boost converter (2) provides necessary supply voltage for the amplifier (3).

Fig. 2 illustrates a boost voltage from the DC-DC boost converter (2) and an amplifier's output signal from the amplifier (3) which are generated by the electronic circuit using the DC-DC boost converter in Fig. 1. The DC-DC boost converter, shown in Fig. 1, increases the supply voltage for the amplifier (3) when the battery voltage is not sufficient. This is shown in Fig. 2. The DC-DC boost converter (2) shown in Fig. 1 increases for example the supply voltage from 4 V coming from the battery (1) to 12 V, to ensure proper signal swinging for the amplifier (3) without any clipping.

As mentioned above, in mobile applications, audio amplifiers use an internal DC-DC boost converter to increase the supply voltage, resulting in a higher amplifier output power.

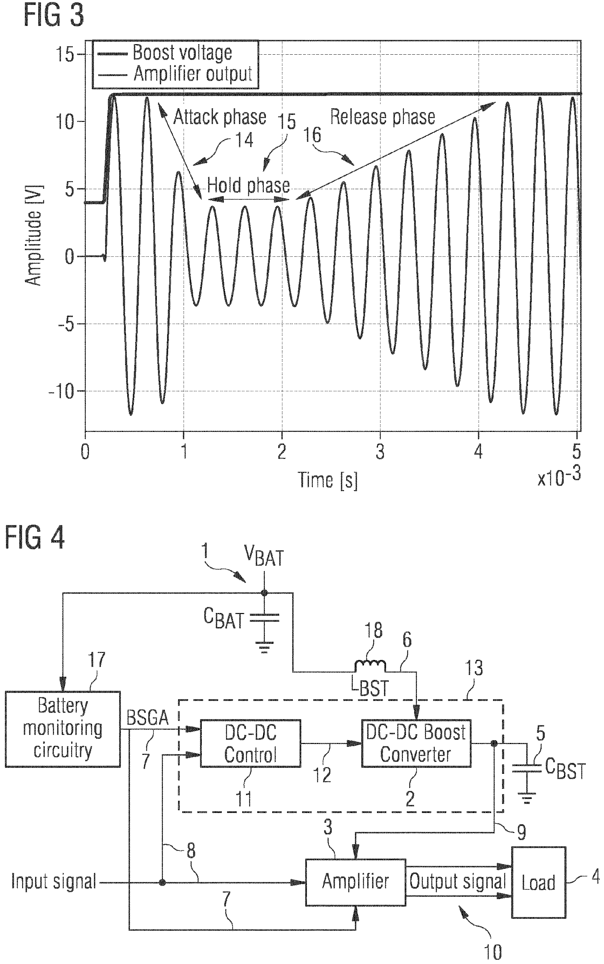

Battery-powered audio devices are also equipped with a battery monitoring circuitry, such as the implementation of a peak current limiting system as described in US 11,490,196 B2. The peak limiting system in US 11,490,196 B2 reduces signal gain and/or battery current consumption when the battery voltage drops below a certain level to limit power consumption. In existing DC-DC boost converters, the reduction in the amplitude of the amplifier's output signal does not impact the boost voltage level. Consequently, when the battery monitoring circuitry intervenes during voltage drop and reduces the amplitude of the amplifier's output signal, the boost voltage level remains unchanged. The lack of adjustment in the boost voltage results in an unnecessary high output voltage. This inefficiency leads to a surge in undesired power consumption, emphasizing the need for enhanced coordination between the battery monitoring circuitry and the DC-DC boost converter to achieve optimal power management. Efficiency, in this context, is the measure of how effectively power resources are utilized. It is determined by the ratio of the desired output power to the total power consumed by the amplifier, hence the desired power and the dissipated power. In the prior art, if the amplitude of the amplifier's output signal is reduced, the DC-DC boost converter continues to supply a high amount of power to the amplifier, which becomes redundant and wasted as dissipated power. This redundancy leads to inefficiency. Fig. 3 illustrates that when amplifier gain is being decreased by the battery monitoring circuitry, the DC-DC boost converter fails to adjust the boost level accordingly.

Two adaptive DC-DC boost tracking algorithms that regulate the boost voltage based on the audio input signal are presented in and known from US 20190131931 A1 and US 9,520,782 B2. In US 20190131931 A1, a boost control signal generator for controlling a DC-DC-booster is provided. The boost control signal generator comprises a boost control input configured to receive an audio signal and a delay line configured to obtain an envelope signal of the audio signal extending the boost activation to start the booster before the audio signals arrives at the amplifier to allow the boost converter to ramp up and to keep booster activated as long as the audio signal level necessitates to generate a boost voltage. By generating a booster control signal from an envelope of an audio signal and a delayed audio signal, the DC-DC-boost control voltage is controlled with minimal headroom and consequently more efficiency without resulting in amplifier clipping.

In US 9,520,782 B2 an audio amplification is disclosed wherein an audio amplifier is controlled based on the audio signal being amplified. For example, when the audio signal level increases or decreases, a boost voltage provided to an audio amplifier by a boost converter may also be increased or decreased. In another example, when the audio signal level decreases below a certain level, the audio amplifier may be switched from amplifying the audio signal with a boost converter input to amplifying the audio signal with a low voltage input. The control of the audio amplifier is implemented in a digital boost converter controller coupled to the boost converter and/or the audio amplifier.

The DC-DC boost converter outlined in US 11,728,779 B2 incorporates a class-H signal tracking algorithm, which dynamically adjusts the boost voltage based on the input signal level. In addition, to address scenarios where battery current consumption approaches its maximum allowable limit, an over-boost mechanism has been implemented to elevate the boost voltage. This requires a high implementation effort as various parameter, e. g. a peak output signal of a signal path, energy requested over a period of time by the signal path, available energy from an energy source to a power converter, stored energy at an output of a power converter, and stored energy of a battery for providing electrical energy at the input are needed to generates an intermediate signal that is used to prevent clipping of an audio signal due to a decrease in amplifier supply voltage.

Given the absence of alignment between the battery monitoring circuitry and the DC-DC boost converter in the aforementioned examples, there is a need for enhanced coordination between these components to achieve optimal power management when battery voltage drops.

So, the objective of the present invention is to provide a cost-efficient and effective apparatus and method to achieve an optimal power management between a battery monitoring circuitry and a DC-DC boost converter to minimize power consumption from the battery and enhances overall battery life.

### Summary of the invention

The objective will be solved by the apparatus according to independent claim 1. The apparatus for adaptive boost voltage adjustment comprises a DC-DC control unit for controlling and adjusting an input voltage of a DC-DC boost converter connected to the DC-DC control unit, an amplifier for amplifying an audio input signal coupled to the amplifier and outputting an output signal coupled to a load, whereas the amplifier is powered by an adaptive DC-DC boost converter which comprises the DC-DC control unit and the DC-DC boost converter, and the adaptive DC-DC boost converter is powered by a battery, whereas the apparatus further comprises a battery monitoring circuitry which is configured to monitor an output voltage of the battery and to regulate an amplitude of the amplifier's output signal accordingly. According to the inventive apparatus for adaptive boost voltage adjustment, the DC-DC control unit comprises an amplifier gain adjustment input for adjusting a boost voltage of the DC-DC boost converter based on the output of the battery monitoring circuitry.

In an embodiment, the amplifier gain adjustment applied by the battery monitoring circuitry be incorporated as an input for the DC-DC control unit in the adaptive DC-DC boost converter and the amplifier. Incorporating an amplifier gain adjustment input for the DC-DC control unit is a further development of the DC-DC boost structure presented in US 20190131931 A1. Throughout the invention, the output of the battery monitoring circuitry is called Battery Safeguard Gain Adjustment (BSGA) and is the amplifier gain adjustment input.

Modern DC-DC boost converters are equipped with an adaptive controller that adjusts the boost voltage based on the audio input level, meaning the boost voltage adjusts to the audio input signal's envelope, constantly adapting to changing voltage requirements. The adaptive nature minimizes power consumption from the battery and enhances overall battery life.

In a variant of the inventive apparatus, the DC-DC control unit is configured to decrease a signal gain of a DC-DC boost converter output when an amplitude of the amplifier gain adjustment input signal (BSGA) increases. This phase is called attack phase. When the battery voltage falls below a battery threshold level, the battery monitoring circuitry prompts the BSGA (battery safeguard gain adjustment) input to increase, thereby reducing the output signal gain of the amplifier. The attack response must be relatively fast to promptly reduce the output signal gain, preventing excessive battery current consumption. In other words, the output voltage signal of the adaptive DC-DC boost converter is adapted to the decrease in the amplifier's output signal gain accordingly, resulting in a minimization of the power consumption of the battery.

In another variant of the inventive apparatus, the DC-DC control unit is configured to maintain a signal gain of the DC-DC boost converter output when the amplitude of the amplifier gain adjustment input signal (BSGA) remains constant/unchanged. Therefore, no further gain adjustment of the adaptive DC-DC boost converter output occurs. This phase is called hold phase. In this phase, the battery voltage goes above the battery threshold level, but the BSGA input signal remains constant/unchanged for a specified duration. The hold phase serves as a transitional phase between the attack and release phases, preventing the occurrence of audible audio artifacts. In other words, as the output signal gain of the amplifier is still constant/unchanged, the output voltage signal of the adaptive DC-DC boost converter remains constant too. Energy wasting or clipping of the audio signal are avoided.

In a further variant of the inventive apparatus, the DC-DC control unit is configured to increase a signal gain of the DC-DC boost converter output when the amplitude of the amplifier gain adjustment input signal (BSGA) decreases. This phase is called release phase. In the release phase, when the battery voltage goes above the battery threshold level and the hold phase has concluded, the battery protection circuitry triggers the BSGA input to decrease, allowing the gain of the amplifier's output signal to return to its original level prior to the intervention of the battery monitoring circuitry. In other words, the output voltage signal of the adaptive DC-DC boost converter is adjusted to the increase in the amplifier's output signal gain accordingly, thus preventing the risk of signal clipping in the amplifier output.

In another further variant of the inventive apparatus, the amplitude of the amplifier gain adjustment input signal (BSGA) influences a dynamic gain part G_{D,dynamic} of a generated boost voltage, V_{boost}, in the DC-DC boost converter, whereas V_{boost} is defined as V_{boost} = audio_level*G_{D,dynamic}*G_{D,static}*G_{A} + headroom, where audio_level represents a normalized amplitude of the digital audio input signal of the amplifier, and G_{D} and G_{A} represent digital and analog gain of the amplifier, respectively, whereas the digital gain G_{D} consists of static G_{D,static} and dynamic G_{D,dynamic} gains. Since the BSGA input is connected to both the adaptive DC-DC boost converter and the amplifier, the boost voltage exhibits a similar behavior to the amplifier's output signal. The BSGA signal is continuously adjusted based on the battery voltage. When the battery voltage falls below the battery threshold level, the BSGA value increases. As a result, both the gain of the amplifier's output signal and the adaptive DC-DC boost voltage are reduced. Conversely, when the battery voltage surpasses the battery threshold level, the BSGA value is decreased, resulting therein that both the gain of the amplifier's output signal and the adaptive DC-DC boost voltage are increased. The BSGA value may remain unchanged depending on the user's settings which results in both the gain of the amplifier's output signal and the adaptive DC-DC boost voltage are remained unchanged. Hence, the BSGA value effectively functions as the dynamic gain controller for the boost voltage. The static gain G_{D,static} includes any gain settings configured by the user according to the setup. The headroom is an adjustable margin to allow to generate a boost voltage which is large enough to avoid clipping, but not too large to lead to losing efficiency. The BSGA value can take any integer value greater than zero, representing the level of voltage gain adjustment in the amplifier's output signal. The limitation of BSGA value may vary depending on different implementations of battery monitoring circuitry. The inventive apparatus is designed to accommodate any methods that adjust the gain in the amplifier's output signal. In this invention, a BSGA value of zero indicates no adjustment in gain in the amplifier's output signal, while an increase in BSGA value results in larger gain reduction. Consequently, during the attack phase, the BSGA value increases, remains unchanged during the hold phase, and decreases during the release phase.

The objective of the invention is also solved by a method according to independent claim 6. The inventive method for generating an adaptive boost voltage uses the apparatus for adaptive boost voltage adjustment according to the apparatus claims. The inventive method comprises the following steps:
- inputting an audio input signal to a DC-DC control unit and an amplifier,
- monitoring a battery voltage of a battery supply, and
- dynamically adjusting an amplitude of an amplifier gain adjustment (BSGA) input signal depending on the detected battery voltage, wherein
- a boost voltage of an adaptive DC-DC boost converter is adjusted based on the amplifier gain adjustment input signal (BSGA) and the audio input signal.

In a variant of the inventive method, if the monitored battery voltage of the battery supply falls below a battery threshold level, the amplitude of the amplifier gain adjustment input signal (BSGA) increases, thereby the signal gain of the adaptive DC-DC boost converter output decreases. The battery threshold level is set by the user. When the battery voltage falls below the battery threshold level, it prompts the BSGA (battery safeguard gain adjustment) input signal to increase, thereby adjusting the output signal gain of the adaptive DC-DC boost converter. The attack response must be relatively fast to promptly reduce the signal gain, preventing excessive battery current consumption.

In another variant of the inventive method, if the monitored battery voltage of the battery supply surpasses the battery threshold level, the amplitude of the amplifier gain adjustment input signal (BSGA) remains unchanged for a specific duration, and the signal gain of the adaptive DC-DC boost converter output remains constant for that specified duration too. This hold phase serves as a transitional phase between the attack and release phases, preventing the occurrence of audible audio artifacts. The specified duration is set by the user and allows a trade-off between performance and battery lifetime.

In a further variant of the inventive method, if the monitored battery voltage of the battery supply surpasses the battery threshold level and the hold phase has concluded, the amplitude of the amplifier gain adjustment input signal (BSGA) decreases thereby the signal gain of the adaptive DC-DC boost converter output increases.

In another further variant of the inventive method, the adaptive DC-DC boost converter consistently generates sufficient boost voltage to avoid any clipping of the audio signal.

Normally, signal tracking algorithms monitor the audio input signal to generate a boost voltage which is large enough to avoid clipping, but not too large to lead to losing efficiency. Usually there is an adjustable headroom as follows: V_{boost} = Vₐₘₚ + headroom (eq. I), with Vₐₘₚ represents the amplifier output which can be formulated as: Vₐₘₚ = audio_level * G_{D} * G_{A} (eq. II), where audio_level is the normalized amplitude of digital audio input signal and G_{D} and G_{A} represent digital and analog gain, respectively. The headroom is an adjustable margin to allow to generate a boost voltage which is large enough to avoid clipping, but not too large to lead to losing efficiency. The digital gain G_{D} consists of static and dynamic gains, where the dynamic gain G_{D,dynamic} is influenced by the fact that BSGA value adjusts the amplifier's output signal gain as needed. The static gain G_{D,static} includes any gain settings configured by the user. The eq. I can be reformulated as: V_{boost} = audio_level*G_{D,dynamic}*G_{D,static}*G_{A} + headroom (eq. III).

It can be inferred that audio input signal is superimposed on the dynamic digital gain signal or in other words BSGA modulate the audio signal. Different settings for various headroom values remain unaffected.

This disclosure presents a cost-effective solution designed to shape the boost voltage, which results in minimizing power consumption, enhancing power management, and extending battery life. Through this invention, when the amplifier's output signal decreases, the boost voltage also decreases. Consequently, less power is required by the amplifier from the battery supply, resulting in reduced battery current consumption and lower overall power consumption. This solution effectively regulates the amplifier's power supply voltage based on the output signal amplitude, thereby enhancing power management, and extending battery life by minimizing the need for high battery current. The proposed solution achieves an optimal outcome by dynamically increasing or decreasing the boost voltage when necessary while maintaining the benefits from the adaptive features of the booster. This adaptability is based not only on the audio input signal but also on the BSGA value, effectively modulating the audio signal.

### Brief Description of the Drawings

The invention will be explained in more detail using exemplary embodiments.

The appended drawings show
- Fig. 1: Block diagram of an electronic circuit using a DC-DC boost converter;
- Fig. 2: DC-DC boost converter generates required supply voltage for amplifier to avoid clipping;
- Fig. 3: Boost voltage and audio signal amplitude when battery monitoring circuitry is intervening;
- Fig. 4: Block diagram of an electronic circuit using an adaptive DC - DC boost converter with adaptive gain adjustment capability according to the invention;
- Fig. 5: According to the invention: Boost voltage dynamically changes as BSGA value dictates and modulates the audio signal amplitude;
- Fig. 6: An example of a battery monitoring circuitry method.

### Description of Embodiments

Figure 4 shows a block diagram of an electronic circuit using an adaptive DC-DC boost converter 13 according to an embodiment of the invention. The adaptive boost voltage adjustment circuit comprises a DC-DC control unit 11 with a battery safeguard gain adjustment input 7, also called amplifier gain adjustment input. An audio input signal 8 may be connected to an audio amplifier 3 which may for example be a class-D audio amplifier. An amplifier output 10 may be connected to a load 4, for example a speaker.

The DC-DC boost converter 2 may have a supply input 6 connected to an inductance 18 which is in series with a battery 1. The DC-DC boost converter 2 may have an output 9 connected to the amplifier 3 and a charging capacitor 5 which stabilizes the output voltage.

The DC-DC control unit 11 may have an output 12 connected to a control input of the DC-DC boost converter 2. The DC-DC control unit 11 may have an input 8 connected to the audio input signal. The DC-DC boost converter 2 and the DC-DC control unit 11 forming the adaptive DC-DC boost converter 13.

According to the invention, the DC-DC control unit 11 and the amplifier 3 may have an amplifier gain adjustment input 7, also called a battery safeguard gain adjustment (BSGA) input in this invention.

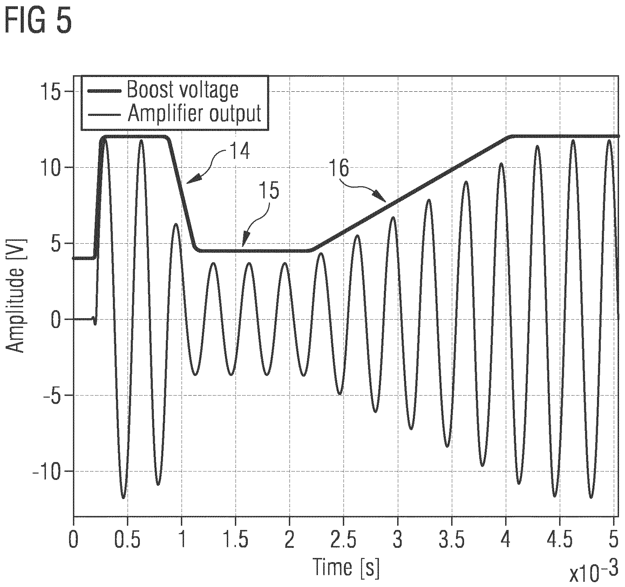

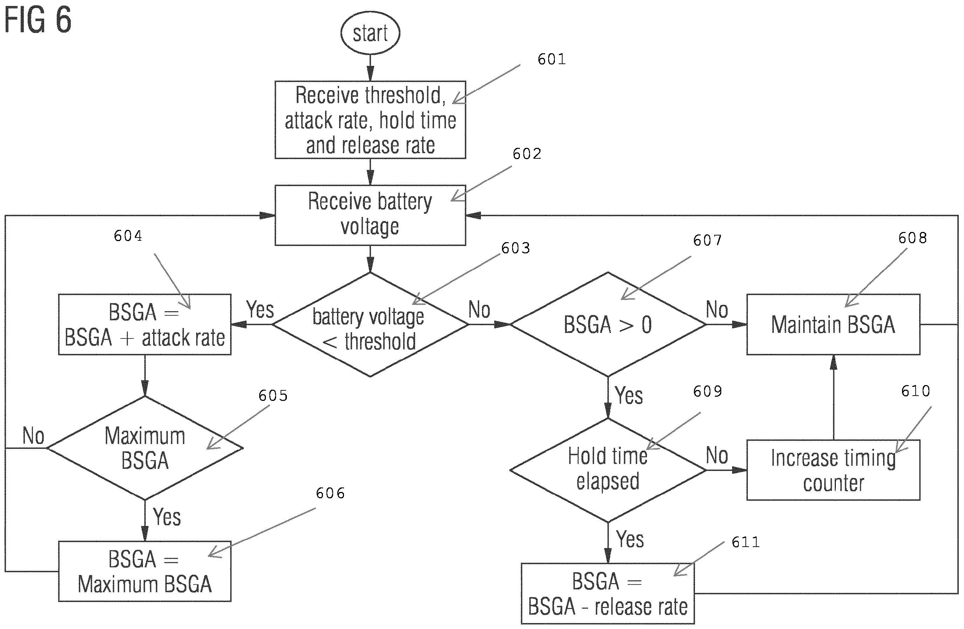

Figure 5 depicts the boost voltage behaving dynamically when the amplitude of the amplifier's output signal 10 is reduced by the battery monitoring circuitry 17. The battery monitoring circuitry or system employs a method that reduces the output signal gain of the amplifier. Although the inventive apparatus is designed to accommodate any methods that adjust the output signal gain of the amplifier, Fig. 6 illustrates an example of battery monitoring circuitry method. The method shown in Fig. 6 comprises following steps:
1) Configurable parameters, including threshold, attack rate, hold time, and release rate, are initially set up to tailor the algorithm's behavior 601.
2) The algorithm continuously monitors the battery voltage to ensure timely responses to changes 602.
3) Upon detecting 603 that the battery voltage falls below the threshold level, the algorithm triggers an adjustment in the Battery Safeguard Gain Adjustment (BSGA) signal.
4) Initially, BSGA value is incrementally increased 604 by the attack rate until it reaches its maximum 605 required value, which is calculated as the difference between the battery threshold level and the current battery voltage, both digitized by an analog-to-digital converter (ADC).
5) Once BSGA reaches its maximum value, the algorithm maintains this value 606 while continuously monitoring the battery voltage 602.
6) If the battery voltage exceeds the battery threshold level, the algorithm assesses the current level of BSGA 607.
7) If BSGA is found to be zero, indicating no amplifier gain adjustment, the algorithm maintains 608 the current BSGA value, in this case equal to zero. As mentioned earlier, the hold phase serves as a transition between the attack and release phases, preventing the occurrence of audio artifacts. Since there is no amplifier gain adjustment, and consequently no attack phase, there is no need for a transitional phase. Therefore, the algorithm proceeds to monitor the battery voltage for further changes 602.
8) In case where BSGA value is greater than zero, the algorithm checks if the hold time has elapsed 609.
9) While the hold time is still in progress, which means that the hold time has not elapsed, the algorithm continuously incrementing a timing counter 610, maintain 608 the BSGA value, and monitoring the battery voltage 602.
10)Upon completion of the hold time, which means that the hold time has elapsed, the algorithm initiates a reduction 611 in BSGA value by the specified release rate.
11)Subsequently, the algorithm returns to its primary task of monitoring the battery voltage 602.

It is important to note that the above method serves as a simplified example of battery monitoring circuitry. Depending on specific requirements, different methods may include additional intermediate steps or consider other factors.

To illustrate the method more clearly, a numerical example is considered: The battery voltage is supposed to fluctuate from 4 V to 2 V and then back to 4 V. The parameters will be configured as follows: attack rate of 1/step, release rate of 1/step, hold time of 1 ms, and a threshold set at 2.5 V. The method utilizes an analog-to-digital converter (ADC) to monitor the battery voltage. The battery monitoring circuitry may include the analog-to-digital converter (ADC) to digitize the battery voltage. Assuming an ADC with 6-bit resolution and a maximum battery voltage of 10, the digital value of the battery voltage, when 2 V is calculated as (2/10)*63 = 12, is 12. Similarly, the digital value for the threshold is (2.5/10)*63 = 15. Consequently, the Battery Safeguard Gain Adjustment (BSGA) can reach a maximum of 15-12 = 3. BSGA value incrementally increases by 1 per step, requiring three steps to reach 3 as the battery voltage falls below the battery threshold level. After remaining constant for 1 ms as the battery voltage rises back above the battery threshold level, BSGA value starts to decrease by 1 per step, taking another three steps to return to zero. The above mentioned method operates in three primary phases:
1) Attack phase 14: when the battery voltage falls below the battery threshold level, it prompts the BSGA (battery safeguard gain adjustment) value to increase, thereby reducing the output signal gain. The attack response must be relatively fast to promptly reduce the signal gain, preventing excessive battery current consumption.
2) Hold phase 15: in this phase, the battery voltage surpasses the battery threshold level, but the BSGA value remains constant for a specified duration. The hold state serves as a transitional phase between the attack and release phases, preventing the occurrence of audible audio artifacts.
3) Release phase 16: as the battery voltage surpasses the battery threshold level and the hold phase has concluded, the BSGA value is reduced. Depending on the requirements, a larger or smaller release rate can be chosen.

The disclosure of the invention presents a cost-effective solution designed to shape the boost voltage, which results in minimizing power consumption, enhancing power management, and extending battery life. The proposed solution achieves an optimal outcome by dynamically increasing or decreasing the boost voltage when necessary while maintaining the benefits from the adaptive features of the booster. This adaptability is based not only on the audio input signal but also on the BSGA value, effectively modulating the audio signal.

Another key advantage of this solution, compared to the DC-DC boost converters referenced in US 20190131931 A1, US 9,520,782 B2, and US 11,728,779 B2, as well as other general DC-DC boost converters, lies in its ability to prevent output signal clipping. In existing boost converters, the maximum battery current consumption is determined by an input. When battery monitoring circuitry reduces the battery current limit, the boost converter typically maintains a high supply voltage for the amplifier. This potentially allows the load to draw more current from the battery. However, the boost converter is forced to decrease current consumption, which results in output signal clipping. In contrast, the proposed solution emulates the behavior of the battery monitoring circuitry, ensuring the boost converter consistently generates sufficient boost voltage. The inventive apparatus and method enable that the DC-DC control (11) utilizes the BSGA input to ensure that the output signal (9) of the DC-DC boost converter mimics precisely the behavior of the amplifier's output signal, which is regulated by the battery monitoring circuitry. This innovative approach eliminates the occurrence of clipping in the output signal, contributing to an improved overall performance.

### List of Reference Signs

- 1: battery supply
- 2: DC-DC boost converter
- 3: Amplifier
- 4: Load, e. g. loudspeaker
- 5: Charging/boost capacitor
- 6: Supply input
- 7: Amplifier gain adjustment input (BSGA), output of the battery monitoring circuitry, amplifier gain adjustment input signal
- 8: Audio input signal
- 9: Output of the DC-DC boost converter
- 10: Amplifier output
- 11: DC-DC control unit
- 12: Output of the DC-DC control unit
- 13: Adaptive DC-DC boost converter
- 14: Attack phase
- 15: Hold phase
- 16: Release phase
- 17: Battery monitoring circuitry
- 18: Boost inductor 601-611 method steps

## Claims

1. An apparatus for adaptive boost voltage adjustment comprising an adaptive DC-DC boost converter (13) and an amplifier (3) for amplifying an audio input signal (8) coupled to the amplifier (3) and outputting an output signal (10) coupled to a load (4), whereas the amplifier (3) is powered by an adaptive DC-DC boost converter (13), and the adaptive DC-DC boost converter (13) is powered by a battery (1), the apparatus for adaptive boost voltage adjustment is **characterized in, that** the apparatus further comprises a battery monitoring circuitry (17) which is configured to monitor an output voltage of the battery (1) and output an amplifier gain adjustment input signal (7), and whereas the adaptive DC-DC boost converter (13) is configured to adjust a boost voltage of the adaptive DC-DC boost converter (13) based on the amplifier gain adjustment input signal (7).

2. The apparatus according to claim 1, wherein an adaptive DC-DC boost converter (13) comprises a DC-DC control unit (11) and a DC-DC boost converter (2) connected to the DC-DC control unit (11); and the DC-DC control unit (11) is configured to adjust an input voltage (12) of the DC-DC boost converter (2) so as to decrease, maintain or increase the signal gain of the boost voltage of the adaptive DC-DC boost converter (13) based on the amplitude of the amplifier gain adjustment input signal(7); and the battery monitoring circuitry connected to the DC-DC control unit (11) is configured to output the amplifier gain adjustment input signal (7) to the DC-DC control unit (11).

3. The apparatus according to claim 1, wherein the battery monitoring circuitry is configured to increase the amplifier gain adjustment input when the battery voltage falls below a battery threshold level, and the battery monitoring circuitry is configured to decrease or maintain the amplifier gain adjustment input when the battery voltage goes above the battery threshold level.

4. The apparatus according to claim 3, wherein the battery monitoring circuitry is configured to increase the amplifier gain adjustment input until amplifier gain adjustment input equals to a maximum when the battery voltage falls below the battery threshold level.

5. The apparatus according to claim 3, wherein the battery monitoring circuitry is configured to decrease the amplifier gain adjustment input when the battery voltage goes above the battery threshold level and when the amplifier gain adjustment input is greater than zero and when a hold time has elapsed.

6. The apparatus according to claim 3, wherein the battery monitoring circuitry is configured to maintain the amplifier gain adjustment input in one of the following conditions: when the battery voltage goes above the battery threshold level and when the amplifier gain adjustment input is zero; or when the battery voltage goes above the battery threshold level and when the amplifier gain adjustment input is greater than zero and the hold time has not elapsed.

7. The apparatus according to claim 1, wherei n the adaptive DC-DC boost converter (13) is configured to decrease a signal gain of the boost voltage of the adaptive DC-DC boost converter (13) when an amplitude of the amplifier gain adjustment input signal (7) increases.

8. The apparatus according to claim 1, **wherein** the adaptive DC-DC boost converter (13) is configured to maintain a signal gain of the boost voltage of the adaptive DC-DC boost converter (13) when the amplitude of the amplifier gain adjustment input signal (7) remains unchanged.

9. The apparatus according to claim 1, wherein the adaptive DC-DC boost converter (13) is configured to increase a signal gain of the boost voltage of the adaptive DC-DC boost converter (13) when the amplitude of the amplifier gain adjustment input signal (7) decreases.

10. The apparatus according to one of the former claims, wherein the amplitude of the amplifier gain adjustment input signal (7) influences a dynamic gain part G_{D,dynamic} of the generated boost voltage V_{boost} of the adaptive DC-DC boost converter (13), whereas V_{boost} is defined as V_{boost} = audio_level*G_{D,dynamic}*G_{D,static}*G_{A} + headroom, where audio_level represents a normalized amplitude of a digital audio input signal of the amplifier and G_{D} and G_{A} represent digital and analog gain of the amplifier (3), whereas the digital gain G_{D} consists of static G_{D,static} and dynamic G_{D,dynamic} gains, and the amplitude of the amplifier gain adjustment input signal (7) is an integer value.

11. A method for generating an adaptive boost voltage using the apparatus for adaptive boost voltage adjustment according to claims 1 to 10, the method comprising the following steps:
- inputting an audio input signal (8) to an adaptive DC-DC boost converter (13) and an amplifier (3),
- monitoring a battery voltage of a battery supply (1), and
- dynamically adjusting an amplitude of an amplifier gain adjustment input signal (7) depending on the detected battery voltage, wherein
- a boost voltage of the adaptive DC-DC boost converter (13) is adjusted based on the amplifier gain adjustment input signal (7), and the audio input signal (8).

12. The method according to claim 11, wherein if the monitored battery voltage of the battery supply (1) falls below a battery threshold level, the amplitude of the amplifier gain adjustment input signal (7) increases thereby a signal gain of the boost voltage of the adaptive DC-DC boost converter (13) decreases.

13. The method according to one of the former claims 11 to 12, wherein if the monitored battery voltage of the battery supply (1) surpasses a battery threshold level, the amplitude of the amplifier gain adjustment input signal (7) remains unchanged for a specific duration, and the signal gain of the boost voltage of the adaptive DC-DC boost converter (13) remains constant for that specified duration too.

14. The method according to one of the former claims 11 to 13, **wherein** if the monitored battery voltage of the battery supply (1) surpasses a battery threshold level, the amplitude of the amplifier gain adjustment input signal (7) decreases thereby the signal gain of boost voltage of the adaptive DC-DC boost converter (13) increases.

15. The method according to one of the former claims 11 to 14, wherein a hold phase serves as a transitional phase between an attack phase and a release phase, preventing the occurrence of audible audio artifacts and in the hold phase, the battery voltage surpasses a battery threshold level, but the amplitude of the amplifier gain adjustment input signal remains constant for a specified duration; and in the attack phase, the battery voltage falls below the battery threshold level which prompts the amplitude of the amplifier gain adjustment input signal to increase; and in the release phase, as the battery voltage surpasses the battery threshold level and the hold phase has concluded, the amplitude of the amplifier gain adjustment input signal is reduced.
